# EUROPEAN PATENT APPLICATION

(11) **EP 4 597 834 A1**
(43) Date of publication of application: **06.08.2025**
(21) Application number: 24155751.1
(22) Date of filing: 05.02.2024
(51) Int. Cl.: H02S 30/20, B64G 1/44, H02S 40/36

(54) **FLEXIBLE SOLAR PANEL ARRAY, SPACECRAFT, METHOD FOR MANUFACTURING A FLEXIBLE SOLAR PANEL ARRAY AND METHOD FOR MAINTAINING A FLEXIBLE SOLAR PANEL ARRAY**

(71) Applicant: Airbus Defence and Space GmbH, 82024 Taufkirchen (DE)
(72) Inventor: Übner, Andreas, 82024 Taufkirchen (DE); Müller, Jürgen, 82024 Taufkirchen (DE); Schlerka, Friedrich, 82024 Taufkirchen (DE)
(74) Representative: Isarpatent

(57) **Abstract**

The present invention provides a flexible solar panel array (10), in particular flexible space deployable solar array, the flexible solar panel array (10) comprising: a first attachment unit (11) and a second attachment unit (12) spaced apart from the first attachment unit (11); a plurality of photovoltaic assembly panels (13) arranged in series between the first attachment unit (11) and the second attachment unit (12), wherein each of the photovoltaic assembly panels (13) comprises at least one solar cell unit (14); a flexible coupling device (15), which is configured to couple the plurality of photovoltaic assembly panels (13), wherein the flexible coupling device (15) is attached to the first attachment unit (11) and to the second attachment unit (12). Moreover, the present invention provides a spacecraft containing such a flexible solar panel array (10). Further, the present invention provides a method for manufacturing a flexible solar panel array as well as a method for maintaining a flexible solar panel array.

## Description

The invention relates to a flexible solar panel array, in particular a flexible space deployable solar array. The invention is furthermore concerned with a spacecraft containing such a flexible solar panel array. Further, the invention relates to a method for manufacturing a flexible solar panel array as well as a method for maintaining a flexible solar panel array.

Most space vehicles are typically powered by solar energy, which is provided by solar generators being attached to the vehicle, either directly mounted to the object or as a deployable structure, most commonly seen on satellites and space stations. High-efficient multi-junction solar cells are commonly used in a broad range of space applications.

Standard solar generators need to be stowed in a compact volume when mounted for the launch on the space vehicle (transport position) and will be deployed to increase the surface area to collect a maximum amount of sunlight that will be converted into electrical power by the solar cells (operating position).

Large power requests for the space vehicles require an enormous amount of energy that needs to be provided by the solar generator, which defines the surface area of the solar generator, depending on the type and efficiency of the solar cells. Usually, the surface area is increased by increasing the number or size of the panels. Nevertheless, there are limiting factors for the panel dimension, which is usually the size of the satellite. The number of panels can be increased, but with the increased mass, additional reinforcement elements are required to achieve reasonable mechanical behavior, which usually leads to additional mass.

The electrical relevant photovoltaic assembly (PVA) usually consists of solar cells, which are electrically connected by interconnectors to so-called solar cell strings, and which are protected and enhanced by bonded cover glasses. This assembly is usually bonded to a support structure with silicone adhesives.

The rigid support structure is commonly designed as a sandwich panel with carbon fiber reinforced plastics (CFRP) face sheets and an aluminum honeycomb core. This design is reasonable electrically conductive. Therefore, an insulation film, typically a polyimide film, separates the PVA from the support structure.

A function of the rigid panels is to provide stiffness to the solar generator and to prevent critical bending of the solar cells and/or the cover glasses, which might result in fracture of the solar cell.

Providing stiffness throughout the complete structure has been proved an efficient way of providing surface for the photovoltaic assembly (PVA). Nevertheless, using rigid structures are usually being traded against mass and for instance deployed Eigenfrequencies, which are dropping due to the high mass.

In general, these known type of solar array structures consist in a large part of mechanically unused mass, which does not contribute to the overall wing performance. To lower the mass of the supporting components which are not generating power, different concepts of flexible support structures for the PVA, which are somehow tensioned, have been established over the years. The most common types are the space station like solar arrays, which is basically a Z-folded flexible blanket stack stowed between two rigid plates, which is then deployed. Another approach are rollable solar arrays. Both types have the potential for mass optimization, but also have drawbacks.

Usually, flexible blankets are stowed between the two rigid plates. The flexible blankets are connected to each other with a hinge line between the adjacent blankets and are Z-folded in stowed configuration. These hinges can be bonded to the blankets as discrete component or be integral to the blanket with a set of interleaving hinge lugs on each side of the blankets and connected with axle(s). In a deployed configuration the flexible blankets are tensioned by dedicated tensioning devices between the rigid plates in order to obtain the required mechanical stiffness. Usually, a harness is routed in parallel to the blankets, which transports the electrical power from each blanket towards the spacecraft.

For example, document US 2023/050780 A1 describes a solar array structure for a satellite or other spacecraft is made up of one or a pair of flexible blanket solar arrays and a deployable frame structure. The deployable frame structure includes a T-shaped yoke structure, a T-shaped end structure, and one or more rigid beams, where the T-shaped yoke structure connects to the spacecraft. When deployed, the frame structure tensions the flexible blanket solar array or arrays between the T-shaped yoke structure and the T-shaped end structure. When stowed, the flexible blanket solar array or arrays are folded in an accordion manner to form a stowed pack or packs between the cross-member arms of the T-shaped yoke structure and the T-shaped end structure of the frame structure, which is also stowed in its own Z-fold arrangement.

The tensioning load of the devices passes through every blanket and every hinge. In consequence, this leads to their deformation which is directly affecting the PVA and particularly the solar cells. In order to mitigate partly the effects of deformation and membrane wrinkling, a sophisticated tensioning system is required or stiffer interface parts, so-called spreader plates, are introduced to the solar array at both ends of the solar sail in order to distribute the load more evenly. This is increasing mass and especially complexity of the concepts, which in the end adds on cost.

Taking the above mentioned issues into account, an object of the present invention is to provide a flexible solar panel array which is robust against failures in the structure and keeps the mass low.

According to the invention, this problem is solved in each case by the subject matters of the independent claims.

According to a first aspect of the invention, a flexible solar panel array, in particular a flexible space deployable solar array, is provided. The flexible solar panel array comprises a first attachment unit and a second attachment unit spaced apart from the first attachment unit. The flexible solar panel array further comprises a plurality of photovoltaic assembly panels arranged in series between the first attachment unit and the second attachment unit. Each of the photovoltaic assembly panels comprises at least one solar cell unit. Further, the flexible solar panel array comprises a flexible coupling device, which is configured to couple the plurality of photovoltaic assembly panels. The flexible coupling device is attached to the first attachment unit and to the second attachment unit.

According to a second aspect of the invention, a spacecraft is provided. The spacecraft comprises a flexible solar panel array according to the first aspect of the invention.

According to a third aspect of the invention, a method for manufacturing a flexible solar panel array, in particular a flexible solar panel array according to the first aspect of the invention, is provided. The method comprises a step of providing a plurality of photovoltaic assembly panels, wherein each of the photovoltaic assembly panels comprises at least one solar cell unit. Moreover, the method comprises a step of coupling a flexible coupling device to the plurality of photovoltaic assembly panels such that the plurality of photovoltaic assembly panels is arranged in series between a first attachment unit and a second attachment unit spaced apart from the first attachment unit. The method further comprises a step of attaching the flexible coupling device to the first attachment unit and to the second attachment unit.

According to a fourth aspect of the invention, a method for maintaining respectively repairing a flexible solar panel array, in particular a flexible solar panel array according to the first aspect of the invention, is provided. The method comprises a step of opening a coupling between a first photovoltaic assembly panel and a flexible coupling device or interrupting the flexible coupling device. Furthermore, the method comprises a step of extracting the first photovoltaic assembly panel from the plurality of photovoltaic assembly panels. Further, the method comprises a step of inserting a second photovoltaic assembly panel into the plurality of photovoltaic assembly panels to replace the first photovoltaic assembly panel. The method also comprises a step of restoring the coupling of the inserted second photovoltaic assembly panel by coupling the second photovoltaic assembly panel to the flexible coupling device or by fixing together the flexible coupling device.

A fundamental concept of the invention is to provide a supporting methodology of a solar array structure, in particular of a flexible space deployable structure, which provides dedicated load carrying elements. The flexible coupling device can be configured flexible sectionwise or along its entire length. The flexible coupling device can be a load carrying member of the flexible solar panel array. In particular, the flexible coupling device can be the most relevant load carrying member of the flexible solar panel array. Therefore, the flexible coupling device can be qualified for high loads, which is a big advantage in terms of complexity and cost. The flexible coupling device may be robust for any changes in a design of the flexible solar panel array, such as a length of the flexible solar panel array, as long as the maximum applied force in the flexible coupling device is not exceeded. Furthermore, a load path does not need to be interrupted for the plurality of photovoltaic assembly panels or blankets, respectively, as it is commonly done in conventional solar arrays.

The flexible photovoltaic assembly (PVA) panel respectively flexible blanket usually comprises a thin membrane, for example a reinforced polyimide film, with the PVA bonded onto this and have a rather low mass. A load acting on the bonding between the plurality of photovoltaic assembly panels and the flexible coupling device are dynamic loads, which are also low due to the low mass. Thermal and thermo-mechanical loads can be minimized by choosing a material with a similar thermal expansion coefficient as the flexible blanket, or in particular using the same material.

A space between the first and/or second attachment unit and the adjacent photovoltaic assembly panel can be adapted variable. A spreader plate as usually used in conventional solar array systems is not needed according to the invention. Therefore, the space between the first and/or second attachment unit and the adjacent photovoltaic assembly panel can be reduced, in particular can be less than a size of a solar blanket. Using the layout with the flexible coupling device according to the invention can be a system with a defined load path and usually can save mass compared to commonly used systems. As a result, a redundancy and/or safety factors can be reduced. By omitting the spreader plate material, space, weight and/or complexity of the flexible solar panel array can be reduced.

A particular advantage in the solution according to an aspect of the invention is that not each PVA panel, hinge or hinge bonding has to be proved for single point failure since a malfunction of these components would not directly affect the solar array functionality respectively the mission of the flexible solar panel array and the spacecraft according to the invention. Thus, a qualification effort for such components can be reduced.

Advantageously, more material is in a direct load path and will contribute to the global stiffness and strength. Furthermore, a mechanical load on the plurality of photovoltaic assembly panels can be reduced, in particular eliminated. A mass of the flexible solar panel array can be reduced. A reliability of the flexible solar panel array can be increased. Also, a number of parts used for the flexible solar panel array can be reduced compared to known solar arrays. Hence, the flexible solar panel array according to the invention can reduce an overall complexity and/or can provide a higher efficient design.

Another advantage of the present invention is that the design of the flexible solar panel array can be adjusted to be compatible to many other solar array components. For example, a similar deployment mechanism, for example identical deployment hinges, can be used.

Advantageous embodiments and further developments emerge from the description with reference to the figures.

According to some embodiments of the present invention, the plurality of photovoltaic assembly panels is attached to the flexible coupling device by a material bonding like welding or adhesion, by a form fit like a velcro fastener or a lug tab connection, and/or by a press fit like clamps or a magnetic connection. Hence, the plurality of photovoltaic assembly panels can be releasably attached or at least easily interrupted and restored again by the above mentioned attachment types.

Optionally, the flexible coupling device and the at least one solar cell unit are arranged on the same surface of the plurality of photovoltaic assembly panels. Further, the flexible coupling device can comprise or be configured as a continuous tensioning device such as a strap. Therefore, a tensioning force can be applied to the flexible coupling device. For example, the flexible coupling device can comprise two or more straps extending parallel between the first and second attachment unit. Thereby, the plurality of photovoltaic assembly panels is not loaded by the constant tensioning force, which is applied over the complete lifetime, usually 15 years, and the complete temperature range between approximately +130 °C to -205 °C

According to some further embodiments of the present invention, the flexible coupling device is configured as one part extending between the first attachment unit and the second attachment unit, wherein the flexible coupling device is elastically bendable at least in an area between two adjacent photovoltaic assembly panels of the plurality of photovoltaic assembly panels. Hence, the flexible coupling device can act as a hinge between the two adjacent photovoltaic assembly panels or photovoltaic blankets, respectively. In other words, the flexible coupling device can be configured as a continuously part. So the flexible coupling device does not need to be interrupted, for example for any interface or photovoltaic assembly panel. The flexible coupling device can be elastically bendable along its complete extension. Thus, a manufacturing process and/or an installation process of the elastically bendable coupling device can be simplified.

According to some further embodiments of the present invention, the flexible coupling device is physically subdivided into at least two segments, wherein adjacent end portions of the at least two segments are mechanically connected to each other by a segment interface. Hence, each segment can be maintained or changed separately. As a result, a maintenance of the flexible solar panel array can be simplified since the segments can be handled like modules.

For example, the at least two segments can be configured as a kind of chain like strap. Thereby, the chain like strap can carry a continuous load by means of the segment interface. One segment, flexible or rigid, can correspond to one photovoltaic assembly panel or blanket, for instance. The at least two segments can be mechanically connected at the end of the segment by means of the segment interface.

According to some further embodiments of the present invention, the segment interface comprises or is configured as a hinge or as a hinge lug. As a result, the flexible coupling device can provide a defined load path in a deployed configuration without putting a load on the plurality of photovoltaic assembly panels.

For example, a number of segment interfaces can correspond to a number of the plurality of photovoltaic assembly panels. Thus, the at least two segments can be acting like a chain, wherein the segment interface represents a chain link, in particular for every photovoltaic assembly panel. Furthermore, a maintenance of the flexible solar panel array can be simplified, in particular in the deployed or partially deployed configuration.

According to some further embodiments of the present invention, the segment interface comprises a material layer and/or a reinforcement element for reinforcing the segment interface. Thus, the segment interface can be strengthened or further protected against a radiation or both, for example.

According to some further embodiments of the present invention, the flexible coupling device comprises or is made of a fiber reinforced material. For example the fiber reinforced material can be a fiber reinforced plastic, in particular at least one of the group of a carbon fiber reinforced plastic, a glass fiber reinforced plastic, an aramid fiber reinforced plastic and a synthetic fiber reinforced plastic. Alternatively or additionally, the flexible coupling device comprises or is made of stainless steel or a light metal, in particular an aluminum and/or a titanium strip. Further alternatively or additionally, the flexible coupling device comprises or is made of a polyimide material and/or a reinforced polyimide material. For example, there can be a one-dimensional load applying in the flexible coupling device. Therefore, the fiber reinforced material can be ideally oriented for such a load case. As a result, the flexible coupling device is less critical to failure.

According to some further embodiments of the present invention, the first attachment unit, the second attachment unit or both comprises a tensioning mechanism for tensioning the flexible coupling device in a deployed configuration of the flexible solar panel array. As a result, the flexible coupling device can be tensioned by a tensioning force in a deployed configuration, for example, in order to reach a predetermined Eigenfrequency. Therefore, the tensioning mechanism can be attached at one or both ends of the flexible solar panel array on the attachment unit, for example a plate, where the flexible coupling device can be attached to. Furthermore, an applied pre-tension on the flexible coupling device can substantially be kept constant. For example, the tensioning mechanism comprises or is configured as a tension spring.

Furthermore, a plurality of flexible coupling devices can be tensioned by the tensioning mechanism. Further, a strain energy can be stored. The amount of tension can easily be applied by stretching the flexible coupling device to a predetermined length fitting to the deployed configuration.

Alternatively or additionally, the flexible coupling device comprises a tensioning mechanism for tensioning the flexible coupling device. Thus, the tensioning functionality can also be connected to or be integral to the flexible coupling device.

According to some further embodiments of the present invention, the flexible coupling device is configured to transfer electrical signals and/or electrical power. Thus, the flexible coupling device may provide an electrical function, for example like a transfer or signal harness as used in conventional space deployable solar arrays. Furthermore, the flexible coupling device can comprise a harness. An accommodation and a behavior, in particular a dynamic behavior, of the harness can be improved. Moreover, an integration of the harness into the flexible coupling device can be beneficial in terms of stowage volume. The stowage volume is often critical and for a lot of cases is the reason for using flexible solar arrays. Further, the complexity of the system can be reduced.

Alternatively, the flexible coupling device can be configured to be isolated or nonconductive. Hence, the flexible coupling device can be electrically insulated, for example by an insulation film, in order to prevent electrical short circuiting.

For example, each photovoltaic assembly panel can be configured as a flexible, a semi-rigid or a rigid structure.

Optionally, a width of the flexible coupling device can be adjustable, such that the flexible coupling device can easily be adapted in width to increase reliability for an impact of micrometeorites, for example. Such an impact can be withstood, if there is sufficient material respectively strength left.

For example, the at least one solar cell unit can comprise a plurality of solar cell units, which might be mounted on the plurality of photovoltaic assembly panels, wherein adjacent solar cell units of the plurality of solar cell units are electrically connected by a solar cell interconnector. The solar cell interconnector can be configured mechanically flexible, in particular bendable. Thus, the solar cell interconnector can provide a mechanical flexibility to the adjacent solar cell units such that they can pivot relative to each other.

The solar cell unit can comprise a solar cell and a cover glass on top of the solar cell. The cover glass can be bonded to the solar cell by a cover glass adhesive. In particular, the cover glass corresponds to a front side of the solar cell unit. Furthermore, the solar cell can be bonded to the flexible strap device by a solar cell adhesive. The solar cell adhesive can be provided on the rear side of the solar cell unit.

Optionally, the first and/or second attachment unit comprises a tension rocker.

According to some further embodiments of the present invention, the method for manufacturing a flexible solar panel array further comprises a step of placing the plurality of photovoltaic assembly panels in series on an assembly table in the position as they are in a deployed or at least a partially deployed configuration. In the deployed configuration the plurality of photovoltaic assembly panels is arranged in series or a row, respectively, with a predefined gap between adjacent photovoltaic assembly panels or the blankets, respectively.

According to some further embodiments of the present invention, the flexible coupling device is coupled to the plurality of photovoltaic assembly panels with a predetermined pre-tension applying on the flexible coupling device, wherein the predetermined pre-tension substantially corresponds to a pre-tension that is applied in the deployed configuration. Thus, the flexible coupling device and the plurality of photovoltaic assembly panels can be coupled under a load situation similar to the load situation in the deployed configuration. For example, the deployed configuration corresponds to the deployed configuration in orbit. The pre-tension can be applied by means of a pre-tensioning apparatus or an idler pulley with a weight.

According to some further embodiments of the present invention, the step of coupling includes curing the flexible coupling device comprising applying pressure by a weight or a vacuum. For example, an adhesive bonding between the plurality of photovoltaic assembly panels and the flexible coupling device is cured.

Optionally, the method for manufacturing a flexible solar panel array can further comprise a step of integrating a tensioning mechanism into the first and/or second attachment unit for tensioning the flexible coupling device in a deployed configuration of the flexible solar panel array.

According to some further embodiments of the present invention, in the method for maintaining a flexible solar panel array the flexible coupling device can be interrupted by cutting the flexible coupling device, for example. Alternatively or additionally, the coupling between the first photovoltaic assembly panel and the flexible coupling device can be opened by slicing through the coupling, for example an adhesive bonding, with a sheet, for example a sheet made of polyimide, for separating the first photovoltaic assembly panel from the flexible coupling device. Furthermore, the maintenance of the first photovoltaic assembly panel can be done separately when the first photovoltaic assembly panel is extracted from the plurality of photovoltaic assembly panels.

According to some further embodiments of the present invention, the second photovoltaic assembly panel can be the maintained or repaired first photovoltaic assembly panel or a new photovoltaic assembly panel. Furthermore, the coupling can be restored by an adhesive bonding, a sewing, by a fixation by velcro, by a welding, by a magnet, by using a form-fit like a lug tab connection or by clamping. The present invention is explained more specifically below on the basis of the exemplary embodiments indicated in the schematic figures, in which:
- Fig. 1: shows a schematic illustration of a flexible solar panel array according to an embodiment of the invention in a deployed configuration;
- Fig. 2: shows a schematic illustration of a flexible solar panel array according to a further embodiment of the invention comprising segment interfaces;
- Fig. 3: shows a schematic illustration in a detail view of a photovoltaic assembly panel, which is coupled to a flexible coupling device;
- Fig. 4: shows a schematic illustration of a flexible solar panel array according to a further embodiment of the invention in a stowed position;
- Fig. 5: shows a schematic illustration of a flexible solar panel array according to a further embodiment of the invention comprising a first and second attachment unit with a tensioning mechanism;
- Fig. 6: shows a perspective view of a flexible solar panel array according to a further embodiment of the invention;
- Fig. 7: shows a flow chart for a method for manufacturing a flexible solar panel array according to a further embodiment of the invention; and
- Fig. 8: shows a flow chart for a method for maintaining a flexible solar panel array according to a further embodiment of the invention.

The accompanying figures are intended to convey a further understanding of the embodiments of the invention. They illustrate embodiments and are used in conjunction with the description to explain principles and concepts of the invention. Other embodiments and many of the cited advantages emerge in light of the drawings. The elements of the drawings are not necessarily shown to scale in relation to one another. Direction-indicating terminology such as for example "at the top", "at the bottom", "on the left", "on the right", "above", "below", "horizontally", "vertically", "at the front", "at the rear" and similar statements are merely used for explanatory purposes and do not serve to restrict the generality to specific configurations as shown in the figures.

In the figures of the drawing, elements, features and components that are the same, have the same function and have the same effect are each provided with the same reference signs - unless explained otherwise.

In the meaning of the present invention a flexible coupling device comprising two or more straps, which extend parallel between the first and the second attachment unit, also includes one strap that is fixed with its both ends to the first or second attachment unit and turned round at the second or first attachment unit, respectively. For example, the strap can be turned round by a return pulley or similar.

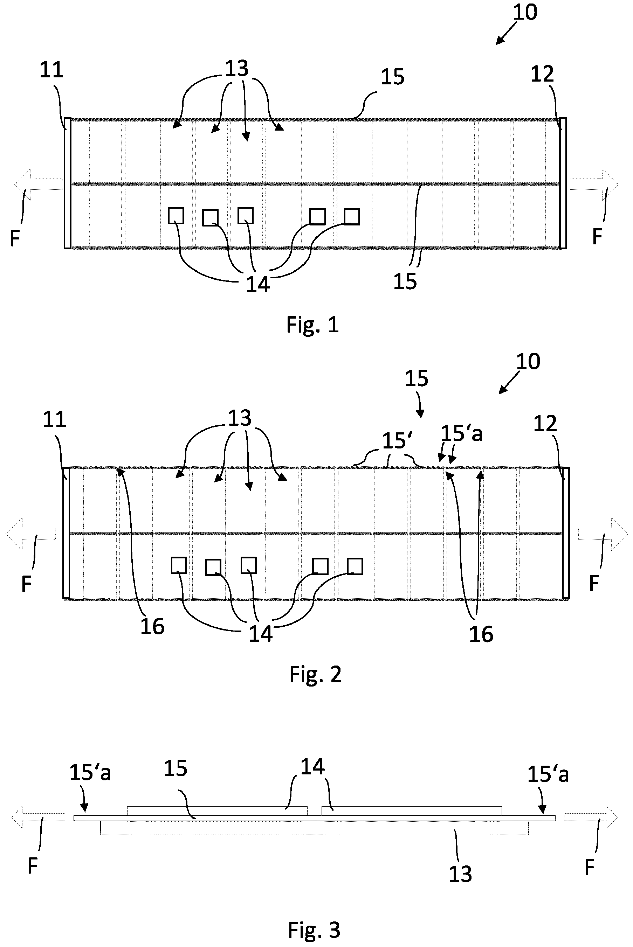

Fig. 1 shows a schematic illustration of a flexible solar panel array 10 according to an embodiment of the invention in a deployed configuration. Specifically, Fig. 1 illustrates a flexible space deployable solar array 10.

The flexible space deployable solar array 10 comprises a first attachment unit 11 and a second attachment unit 12 spaced apart from the first attachment unit 11.

The flexible space deployable solar array 10 further comprises a plurality of photovoltaic assembly panels 13 arranged in series between the first attachment unit 11 and the second attachment unit 12. Each of the photovoltaic assembly panels 13 comprises at least one solar cell unit 14. For example, each photovoltaic assembly panel 13 can be configured as a flexible, a semi-rigid or a rigid structure.

The plurality of photovoltaic assembly panels 13 can be attached to the flexible coupling device 15 by a material bonding like welding or adhesion but is not limited to such an attachment type. Alternatively or additionally, the plurality of photovoltaic assembly panels 13 can be attached to the flexible coupling device 15 by a form fit like a velcro fastener or a lug tab connection, or by a press fit like clamps or a magnetic connection. Hence, the plurality of photovoltaic assembly panels 13 can be releasably attached or at least easily interrupted and restored again by the above mentioned attachment types.

Further, the flexible space deployable solar array 10 comprises a flexible coupling device 15, which is configured to couple the plurality of photovoltaic assembly panels 13. The flexible coupling device 15 is attached to the first attachment unit 11 and to the second attachment unit 12. The flexible coupling device 15 can be configured flexible sectionwise or along its entire length. The flexible coupling device 15 can be a load carrying member of the flexible space deployable solar array 10.

Exemplarily, the flexible coupling device 15 can be configured as one part extending between the first attachment unit 11 and the second attachment unit 12. Thereby, the flexible coupling device 15 is elastically bendable at least in an area between two adjacent photovoltaic assembly panels 13 of the plurality of photovoltaic assembly panels. Alternatively, the flexible coupling device 15 can be elastically bendable along its complete extension. Here, the flexible coupling device 15 can be configured as a continuously part. So the flexible coupling device 15 does not need to be interrupted, for example for any interface or photovoltaic assembly panel 13.

The flexible coupling device 15 can be made of a fiber reinforced material, in particular a carbon fiber reinforced plastic. For example, there can be a one-dimensional load applying in the flexible coupling device 15. Therefore, the fiber reinforced material can be ideally oriented for such a load case.

Furthermore, in the deployed configuration, the flexible coupling device 15 can be tensioned by a tensioning force F.

Fig. 2 shows a schematic illustration of a flexible solar panel array 10 according to a further embodiment of the invention comprising segment interfaces 16.

Specifically, a flexible space deployable solar array 10 is illustrated in Fig. 2, which substantially has the same features as the flexible space deployable solar array 10 as described in Fig. 1. Here, the flexible coupling device 15 can be physically subdivided into segments 15' instead of being one continuously part. Adjacent end portions 15'a of the segments 15' can be mechanically connected to each other by the segment interfaces 16. Hence, each segment 15' can be maintained or changed separately. Therefore, the segments 15' can be handled like modules. The segment interface 16 can be configured as a hinge, for example.

For example, the segments 15' can be configured as a kind of chain like strap. Thereby, the chain like strap can carry a continuous load by means of the hinges 16. One segment 15', flexible or rigid, can correspond to one photovoltaic assembly panel 13 or blanket, for instance. The segments 15' can be mechanically connected at the end of the segment by means of the hinges 16.

As a result, the flexible coupling device 15 can provide a defined load path in a deployed configuration without putting a load on the plurality of photovoltaic assembly panels 13. For example, a number of hinges 16 can correspond to a number of the plurality of photovoltaic assembly panels 13. Thus, the segments 15' can be acting like a chain, wherein the hinge 16 represents a chain link, in particular for every photovoltaic assembly panel.

Moreover, the hinges 16 can comprise a material layer or a reinforcement element for reinforcing the hinges 16. Thus, the hinges 16 can be strengthened or further protected against a radiation or both, for example.

Fig. 3 shows a schematic illustration in a detail view of a photovoltaic assembly panel 13, which is coupled to a flexible coupling device 15. The photovoltaic assembly panel 13 can be integrated in a flexible space deployable solar array 10 of Fig. 2, for example.

Here, the flexible coupling device 15 and the solar cell units 14 are exemplarily arranged on the same surface of the plurality of photovoltaic assembly panels 13. Further, the flexible coupling device 15 can be configured as a strap. For example, the flexible coupling device 15 can comprise two or three straps extending parallel between the first and second attachment unit 11, 12.

For example, the straps 15 can comprise a carbon fiber reinforced plastic (CFRP). For example, carbon fibers are integrated in the straps 15. Exemplarily, the solar cell units 14 can be attached to the photovoltaic assembly panel 13 by a material bonding like adhesion. The straps 15 can be attached to the surface of the photovoltaic assembly panel 13 like the solar cell units.

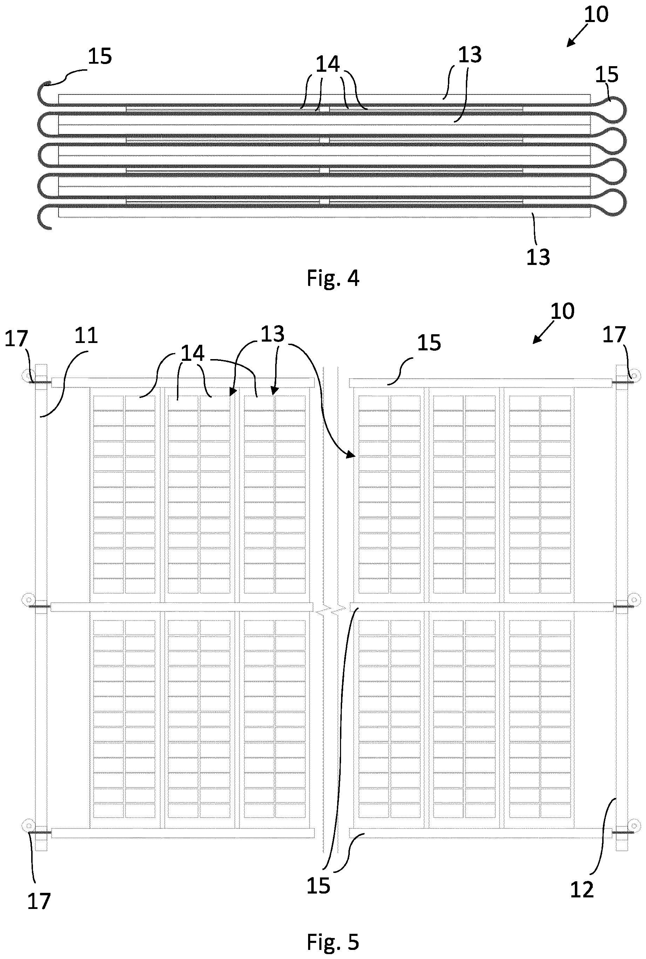

Fig. 4 shows a schematic illustration of a flexible solar panel array 10 according to a further embodiment of the invention in a stowed position. The flexible deployable solar array 10 substantially corresponds to the flexible deployable solar array 10 of Fig. 1 having a continuous flexible coupling device 15.

In particular, Fig. 4 illustrates that the flexible coupling device 15 is elastically bendable at least in an area between two adjacent photovoltaic assembly panels 13 of the plurality of photovoltaic assembly panels. Hence, the flexible coupling device 15 can act as a hinge between the two adjacent photovoltaic assembly panels 13 such that the flexible deployable solar array 10 can be folded.

Fig. 5 shows a schematic illustration of a flexible solar panel array 10 according to a further embodiment of the invention comprising a first and second attachment unit 11, 12 with a tensioning mechanism 17.

The tensioning mechanism 17 can be configured for tensioning the flexible coupling device 15 in a deployed configuration of the flexible solar panel array 10. As a result, the flexible coupling device 15 can be tensioned by a tensioning force F in the deployed configuration, for example, by the tensioning mechanism 17. Therefore, the tensioning mechanism 17 can be attached at one or both ends of the flexible solar panel array 10 on the attachment unit 11, 12.

In case the flexible solar panel array 10 may comprise a plurality of flexible coupling devices 15 or the flexible coupling device 15 may comprise a plurality of straps, each flexible coupling device 15 or each strap can be tensioned by the tensioning mechanism 17. Alternatively, each flexible coupling device 15 or each strap may comprise a tensioning mechanism 17. The amount of tension can easily be applied by stretching the flexible coupling device to a predetermined length fitting to the deployed configuration.

For example, the tensioning mechanism 17 can comprise a tension spring. Furthermore, the first and/or the second attachment unit 11, 12 both may comprise a tension rocker 17.

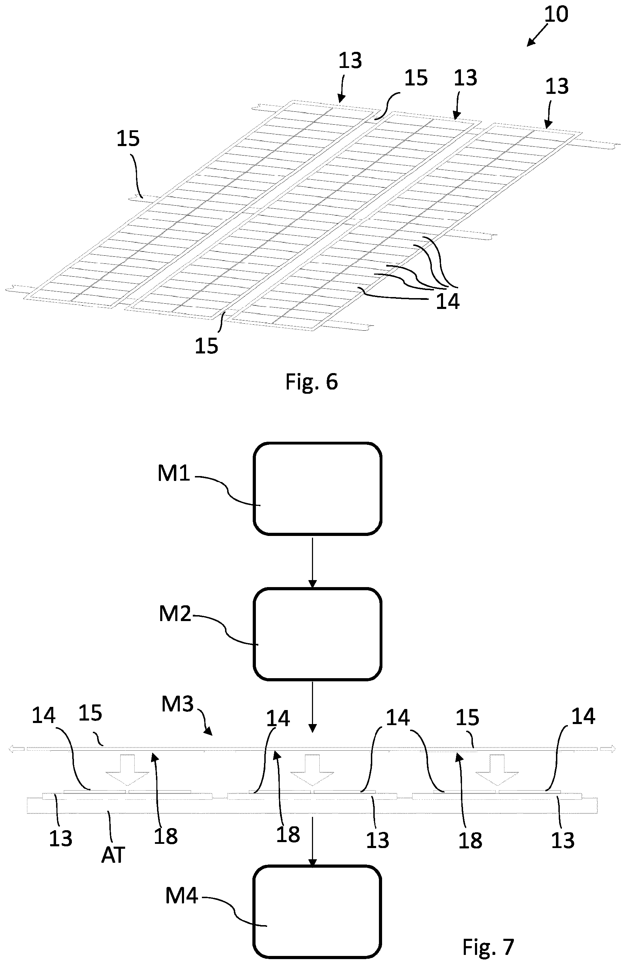

Fig. 6 shows a perspective view of a flexible solar panel array 10 according to a further embodiment of the invention. Specifically, Fig. 6 illustrates the flexible solar panel array 10 comprising three photovoltaic assembly panels 13 attached to a flexible coupling device 15 with three straps. The photovoltaic assembly panels 13 can comprise a plurality of solar cell units 14.

Here, the plurality of solar cell units 14 and the flexible coupling device 15 are attached to different surfaces of the photovoltaic assembly panels 13, for example.

Exemplarily, the flexible coupling device 15 can be configured to transfer electrical signals and/or electrical power. Thus, the flexible coupling device 15 may provide an electrical function, for example like a transfer or signal harness as used in conventional space deployable solar arrays. Furthermore, the flexible coupling device 15 can comprise a harness.

Fig. 7 shows a flow chart for a method for manufacturing a flexible solar panel array 10 according to a further embodiment of the invention.

The method for manufacturing a flexible solar panel array 10 comprises the steps of providing M1, placing M2, coupling M3 and attaching M4.

Exemplarily, the step M3 is illustrated graphically for visualizing this step.

In the step of providing M1, a plurality of photovoltaic assembly panels 13, wherein each of the photovoltaic assembly panels 13 comprises at least one solar cell unit 14 as described in Figs. 1 to 6 is provided.

In the optional step of a step of placing M2, the plurality of photovoltaic assembly panels 13 is placed in series on an assembly table AT in the position as they are in a deployed configuration. In the deployed configuration the plurality of photovoltaic assembly panels 13 is arranged in series or a row, respectively, with a predefined gap between adjacent photovoltaic assembly panels 13.

In the step of coupling M3, a flexible coupling device 15 is coupled to the plurality of photovoltaic assembly panels 13 such that the plurality of photovoltaic assembly panels 13 is arranged in series between a first attachment unit 11 and a second attachment unit 12 spaced apart from the first attachment unit 11. Thereby, the flexible coupling device 15 can be coupled M3 to the plurality of photovoltaic assembly panels 13 with a predetermined pre-tension applying on the flexible coupling device 15. The predetermined pre-tension may substantially correspond to a pre-tension that is applied in the deployed configuration. Thus, the flexible coupling device 15 and the plurality of photovoltaic assembly panels 13 can be coupled under a load situation similar to the load situation in the deployed configuration.

Furthermore, the step of coupling M3 can include curing the flexible coupling device 15 comprising applying pressure by a weight or a vacuum. For example, an adhesive bonding 18 between the plurality of photovoltaic assembly panels 13 and the flexible coupling device 15 is cured.

In the step of attaching M4, the flexible coupling device 15 is attached to the first attachment unit 11 and to the second attachment unit 12.

After performing the steps M1-M4 a flexible solar panel array 10 according to one of the Figs. 1 to 6 can be obtained. Such a flexible solar panel array 10 can be mounted to a spacecraft.

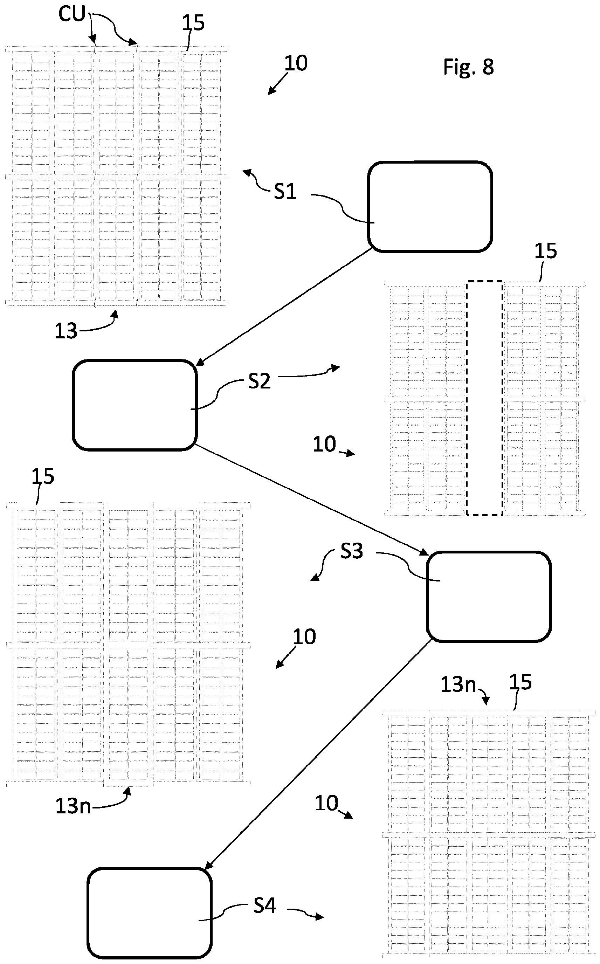

Fig. 8 shows a flow chart for a method for maintaining a flexible solar panel array 10 according to a further embodiment of the invention.

The method for maintaining a flexible solar panel array 10 comprises the steps of opening S1, extracting S2, inserting S3 and restoring S4.

Exemplarily, the steps S1-S4 are illustrated graphically for visualizing those steps.

In the step of opening S1, a coupling between a first photovoltaic assembly panel 13 and a flexible coupling device 15 can be opened. Alternatively or additionally, in the step of opening the flexible coupling device 15 can be interrupted. For example, the flexible coupling device 15 can be interrupted by cutting CU the flexible coupling device.

In the step of extracting S2, the first photovoltaic assembly panel 13 can be extracted from the plurality of photovoltaic assembly panels.

In the step of inserting S3, a second photovoltaic assembly panel 13n can be inserted into the plurality of photovoltaic assembly panels to replace the first photovoltaic assembly panel 13. For example, the second photovoltaic assembly panel 13n can be the maintained/repaired first photovoltaic assembly panel or a new photovoltaic assembly panel.

In the step of restoring S4, the coupling of the inserted second photovoltaic assembly panel 13n can be restored by coupling the second photovoltaic assembly panel 13n to the flexible coupling device 15 or by fixing together the flexible coupling device 15. For example, the coupling can be restored S4 by an adhesive bonding, a sewing, by a fixation by velcro, by a welding, by a magnet, by using a form-fit like a lug tab connection or by clamping..

In the detailed description above, various features have been combined in one or more examples in order to improve the rigorousness of the illustration. However, it should be clear in this case that the above description is of merely illustrative but in no way restrictive nature. It serves to cover all alternatives, modifications and equivalents of the various features and exemplary embodiments. Many other examples will be immediately and directly clear to a person skilled in the art on the basis of his knowledge in the art in consideration of the above description.

The exemplary embodiments have been chosen and described in order to be able to present the principles underlying the invention and their application possibilities in practice in the best possible way. As a result, those skilled in the art can optimally modify and utilize the invention and its various exemplary embodiments with regard to the intended purpose of use. In the claims and the description, the terms "including" and "having" are used as neutral linguistic concepts for the corresponding terms "comprising". Furthermore, use of the terms "a", "an" and "one" shall not in principle exclude the plurality of features and components described in this way.

While at least one exemplary embodiment of the present invention(s) is disclosed herein, it should be understood that modifications, substitutions and alternatives may be apparent to one of ordinary skill in the art and can be made without departing from the scope of this disclosure. This disclosure is intended to cover any adaptations or variations of the exemplary embodiment(s). In addition, in this disclosure, the terms "comprise" or "comprising" do not exclude other elements or steps, the terms "a" or "one" do not exclude a plural number, and the term "or" means either or both. Furthermore, characteristics or steps which have been described may also be used in combination with other characteristics or steps and in any order unless the disclosure or context suggests otherwise. This disclosure hereby incorporates by reference the complete disclosure of any patent or application from which it claims benefit or priority.

### Reference list

- 10: flexible solar panel array
- 11: first attachment unit
- 12: second attachment unit
- 13: (first) photovoltaic assembly panel
- 13n: second photovoltaic assembly panel
- 14: sola cell unit
- 15: flexible coupling device
- 15': segment of the flexible coupling device
- 15'a: end portion of the segment
- 16: segment interface
- 17: tensioning mechanism
- 18: adhesive bonding

- M1: providing a plurality of photovoltaic assembly panels
- M2: placing the plurality of photovoltaic assembly panels
- M3: coupling a flexible coupling device
- M4: attaching the flexible coupling device
- S1: opening a coupling or interrupting a flexible coupling device
- S2: extracting the first photovoltaic assembly panel
- S3: inserting a second photovoltaic assembly panel
- S4: restoring the coupling

- F: tensioning force
- CU: cutting position

## Claims

1. Flexible solar panel array (10), in particular flexible space deployable solar array, the flexible solar panel array (10) comprising:
a first attachment unit (11) and a second attachment unit (12) spaced apart from the first attachment unit (11);
a plurality of photovoltaic assembly panels (13) arranged in series between the first attachment unit (11) and the second attachment unit (12), wherein each of the photovoltaic assembly panels (13) comprises at least one solar cell unit (14);
a flexible coupling device (15), which is configured to couple the plurality of photovoltaic assembly panels (13), wherein the flexible coupling device (15) is attached to the first attachment unit (11) and to the second attachment unit (12).

2. Flexible solar panel array (10) according to claim 1, wherein the plurality of photovoltaic assembly panels (13) is attached to the flexible coupling device (15) by a material bonding like welding or adhesion, by a form fit like a velcro fastener or a lug tab connection, and/or by a press fit like clamps or a magnetic connection.

3. Flexible solar panel array (10) according to claim 1 or 2, wherein the flexible coupling device (15) is configured as one part extending between the first attachment unit (11) and the second attachment unit (12), wherein the flexible coupling device (15) is elastically bendable at least in an area between two adjacent photovoltaic assembly panels (13) of the plurality of photovoltaic assembly panels.

4. Flexible solar panel array (10) according to claim 1 or 2, wherein the flexible coupling device (15) is physically subdivided into at least two segments (15'), wherein adjacent end portions (15'a) of the at least two segments (15') are mechanically connected to each other by a segment interface (16).

5. Flexible solar panel array (10) according to claim 4, wherein the segment interface (16) comprises or is configured as a hinge or as a hinge lug.

6. Flexible solar panel array (10) according to claim 4 or 5, wherein the segment interface (16) comprises a material layer and/or a reinforcement element for reinforcing the segment interface (16).

7. Flexible solar panel array (10) according to one of the preceding claims,
wherein the flexible coupling device (15) comprises or is made of a fiber reinforced material, stainless steel, a light metal, a polyimide material and/or a reinforced polyimide material.

8. Flexible solar panel array (10) according to one of the preceding claims,
wherein the first and/or second attachment unit (11, 12) comprises a tensioning mechanism (17) for tensioning the flexible coupling device (15) in a deployed configuration of the flexible solar panel array (10).

9. Flexible solar panel array (10) according to one of the preceding claims,
wherein the flexible coupling device (15) is configured to transfer electrical signals and/or electrical power.

10. Spacecraft with a flexible solar panel array (10) according to one of the preceding claims.

11. Method for manufacturing a flexible solar panel array, in particular a flexible solar panel array (10) according to one of the claims 1 to 9, the method comprising the steps of:
providing (M1) a plurality of photovoltaic assembly panels (13), wherein each of the photovoltaic assembly panels (13) comprises at least one solar cell unit (14);
coupling (M3) a flexible coupling device (15) to the plurality of photovoltaic assembly panels (13) such that the plurality of photovoltaic assembly panels (13) is arranged in series between a first attachment unit (11) and a second attachment unit (12) spaced apart from the first attachment unit (11);
attaching (M4) the flexible coupling device (15) to the first attachment unit (11) and to the second attachment unit (12).

12. Method according to claim 11, further comprising a step of placing (M2) the plurality of photovoltaic assembly panels (13) in series on an assembly table (AT) in the position as they are in a deployed configuration

13. Method according to claim 11 or 12, wherein the flexible coupling device is coupled (M3) to the plurality of photovoltaic assembly panels (13) with a predetermined pre-tension applying on the flexible coupling device (15), wherein the predetermined pre-tension substantially corresponds to a pre-tension that is applied in the deployed configuration.

14. Method according to one of the claims 11 to 13, wherein the step of coupling (M3) includes curing the flexible coupling device (15) comprising applying pressure by a weight or a vacuum.

15. Method for maintaining a flexible solar panel array, in particular a flexible solar panel array (10) according to one of the claims 1 to 9, comprising the steps of:
opening (S1) a coupling between a first photovoltaic assembly panel (13) and a flexible coupling device (15) or interrupting the flexible coupling device (15);
extracting (S2) the first photovoltaic assembly panel (13) from the plurality of photovoltaic assembly panels;
inserting (S3) a second photovoltaic assembly panel (13n) into the plurality of photovoltaic assembly panels to replace the first photovoltaic assembly panel (13);
restoring (S4) the coupling of the inserted second photovoltaic assembly panel (13n) by coupling the second photovoltaic assembly panel (13n) to the flexible coupling device (15) or by fixing together the flexible coupling device (15).
